Europäisches Patentamt

European Patent Office

Office européen des brevets

(11) Numéro de publication: **0 158 570**
**A1**

# (12) DEMANDE DE BREVET EUROPEEN

(21) Numéro de dépôt: **85420039.1**

(22) Date de dépôt: **06.03.85**

(51) Int. Cl.⁴: **C 30 B 31/10**

(30) Priorité: **12.03.84 FR 8404321**

(43) Date de publication de la demande:
**16.10.85 Bulletin 85/42**

(84) Etats contractants désignés:
**AT BE CH DE GB IT LI NL**

(71) Demandeur: **SERVIN S.A.**
**152-156 avenue Franklin Roosevelt**
**F-69120 Vaulx en Velin Rhône(FR)**

(72) Inventeur: **Servin, Jean-Marc**
**2 chemin de Chantemâle**
**Collonges au Mont d'Or Rhône(FR)**

(74) Mandataire: **Bratel, Gérard et al,**
**Cabinet GERMAIN & MAUREAU Le Britannia - Tour C 20,**
**boulevard E. Deruelle**
**F-69003 Lyon(FR)**

(54) Appareil d'enfournement de nacelles-supports de disques de silicium à l'intérieur d'un four de diffusion gazeuse, utilisé pour la fabrication de micro-circuits intégrés.

(57) Cet appareil assure l'enfournement automatique de nacellessupports (25) chargées de disques de silicium (26), à l'intérieur du tube de traitement (1) d'un four de diffusion gazeuse.

Un boîtier (3), monté déplaçable en translation le long d'une glissière horizontale (2) équipée d'un mécanisme d'avance, porte latéralement une platine (4), montée mobile verticalement et pivotante suivant un axe horizontal (8). Sur la platine (4) est fixé un tube en silice (5) sensiblement horizontal, prolongé par une palette (6) quie reçoit les nacelles (25). La palette (6) est introduite à l'intérieur du tube de traitement (1) avec les nacelles (25); elle peut être retirée du tube (1) après dépose des nacelles (25) au fond de ce tube.

Application à la fabrication de micro-circuits intégrés.

FIG.1

EP 0 158 570 A1

1

**"Appareil d'enfournement de nacelles-supports de disques de silicium
à l'intérieur d'un four de diffusion gazeuse,
utilisé pour la fabrication de micro–circuits intégrés"**

La présente invention est relative à un appareil automatique d'enfournement de nacelles-supports de disques de silicium, matière semi-conductrice, à l'intérieur d'un four de diffusion gazeuse, utilisé pour la fabrication de micro-circuits intégrés.

Un tel four comprend un tube de traitement d'axe horizontal, en silice, ouvert à l'une de ses extrémités de manière à pouvoir recevoir une pluralité de nacelles-supports chargées de disques de silicium. Chaque nacelle-support, réalisée en quartz, possède plusieurs barreaux parallèles qui présentent des séries de fentes dans lesquelles sont positionnés les disques de silicium à traiter. Il convient d'introduire les nacelles à l'intérieur du tube de traitement, et de les en extraire après achèvement du traitement dans le four.

Un procédé classique consiste à placer les nacelles sur un chariot qui est glissé dans le tube de traitement en se déplaçant sur le fond de ce tube, et qui en est extrait de la même manière. Le déplacement du chariot au contact de la paroi intérieure du tube, lors du chargement et du déchargement du four, provoque un soulèvement de particules qui est la cause de défauts sur les micro-circuits obtenus à partir des disques de silicium.

Pour éliminer ce problème, on a déjà proposé des systèmes d'enfournement dans lesquels un bras en porte-à-faux permet d'introduire les nacelles à l'intérieur du tube de traitement du four, et de les en retirer, sans entrer en contact avec la paroi intérieure de ce tube.

Un système particulier, existant sur le marché, permet exclusivement l'enfournement d'un bras-support de nacelles et sa dépose à l'intérieur du four, au fond du tube de traitement, par le basculement d'une autre pièce en silice appelée "insert", qui est engagée dans une extrémité du bras-support. Dans ce système, l'ensemble formé par l'insert et le bras-support en silice est compliqué et coûteux. Le bras reste à l'intérieur du four pendant la chauffe, d'où un risque de déformation de ce bras. Il se pose, par ailleurs, un problème de fermeture étanche de la porte du four. Enfin, l'insert est monté sur un chariot automoteur sur ses propres rails ou glissières, donc ne s'adaptant pas au dispositif d'enfournement classique, propre à chaque four et prévu pour pousser

0158570

2

des chariots ou des nacelles.

Un autre système connu, de la même catégorie, comporte également un chariot automoteur, lequel se déplace le long de deux glissières horizontales. Le principe de fonctionnement est similaire à celui du système décrit précédemment, et en diffère seulement par le fait qu'en position d'enfournement, l'insert en silice bascule et se sépare du bras-support de nacelles, alors que ce dernier repose sur le fond du tube de traitement, puis ledit insert se retire hors du four, pour revenir ultérieurement reprendre le bras et l'extraire. Dans l'ensemble, ce dernier système comporte les mêmes inconvénients que le précédent.

La présente invention vise à éviter tous ces inconvénients, en fournissant un appareil d'enfournement simple et universel, qui volontairement n'est pas de type automoteur mais s'adapte très simplement sur tous les systèmes motorisés d'enfournement existants pour les fours du genre ici considéré.

A cet effet, l'appareil d'enfournement objet de l'invention comprend essentiellement un boîtier monté déplaçable en translation le long d'une glissière horizontale équipée d'un mécanisme d'avance, le boîtier portant latéralement une platine montée mobile verticalement et pivotante suivant un axe horizontal, sur laquelle est fixé un tube en silice ou en silicium ou en carbure de silicium sensiblement horizontal prolongé par une palette apte à recevoir une pluralité de nacelles-supports chargées de disques de silicium et à être introduite à l'intérieur du tube de traitement du four.

L'appareil selon l'invention comporte ainsi un boîtier se fixant très simplement sur un système d'avance existant, donc n'ayant pas à être automoteur. L'ensemble tube-palette monobloc constitue un système de bras également très simple et de fixation aisée sur la platine pivotante, par exemple au moyen d'arceaux, tout "insert" étant supprimé.

Le mouvement vertical de la platine permet de présenter la palette avec les nacelles chargées de disques de silicium à la hauteur voulue, et de déposer éventuellement les nacelles au fond du tube de traitement. Selon une forme de réalisation particulière, l'axe de pivotement de la platine est solidaire d'un support intérieur au boîtier, monté coulissant en direction verticale sur au moins un guide, et déplaçable le long de ce guide vertical par au moins un vérin, ledit support comportant des moyens sensibles au couple de basculement de la platine résultant des efforts exercés sur le bras, ces moyens agissant sur l'alimentation des vérins, notamment pour interrompre automatiquement la descente du support de la platine lorsque la palette parvient au fond du tube.

Ceci peut être avantageusement obtenu en disposant un ressort et un contact électrique de part et d'autre d'une patte faisant saillie latéralement sur la platine et engagée à l'intérieur du boîtier. Au moment où la palette dépose les nacelles au fond du tube de traitement, elle se trouve brusquement allégée et tend à faire basculer la platine dont la patte latérale, poussée par le ressort, viendra alors actionner le contact électrique. De préférence, le ressort est pressé contre la patte latérale de la platine au moyen d'une vis solidaire d'un bouton de réglage, permettant de modifier la sensibilité du dispositif au couple de basculement de la platine.

Selon une forme de réalisation de l'invention, le support de la platine porte encore un autre contact électrique qui coopère avec une butée réglable montée sur le boîtier, et qui agit sur l'alimentation du ou des vérins, ce qui permet d'interrompre automatiquement la descente du support de la platine à un niveau choisi.

Muni de ce dernier agencement, l'appareil d'enfournement selon l'invention peut notamment être utilisé en plaçant, sur la palette prolongeant le tube en silice, un chevalet constituant un support intermédiaire sur lequel sont placées les nacelles-supports chargées de disques de silicium. Le chevalet peut ainsi être déposé au fond du tube de traitement tandis que la palette, libérée de tout son chargement après qu'elle a été descendue jusqu'à un certain niveau, est retirée hors du tube de traitement. En fin de traitement, la palette revient chercher le chevalet pour sortir les nacelles du four.

De toute façon, l'invention sera mieux comprise à l'aide de la description qui suit, en référence au dessin schématique annexé représentant, à titre d'exemple non limitatif, une forme de réalisation de cet appareil d'enfournement :

Figure 1 est une vue d'ensemble, en perspective, montrant un appareil selon l'invention d'enfournement de disques de silicium, avec indication très schématique du four de diffusion gazeuse ;

Figure 2 est une vue en coupe du boîtier de cet appareil, en montrant le mécanisme intérieur ;

Figures 3 à 10 sont des schémas illustrant le fonctionnement, suivant divers modes, de l'appareil d'enfournement objet de l'invention.

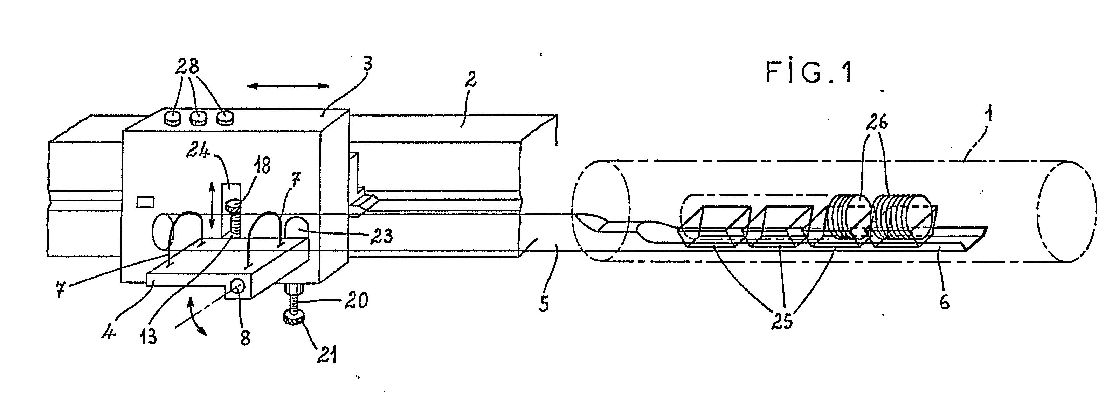

L'appareil d'enfournement, représenté à la figure 1, est associé à un four de diffusion gazeuse comprenant un tube de traitement (1) en silice, cylindrique et d'axe horizontal, et déjà équipé d'un système d'enfournement avec une glissière horizontale (2) et un mécanisme d'avance à vis entraînée par un moteur.

Sur ce mécanisme d'avance est fixé l'appareil proprement dit, comprenant un boîtier (3) de forme générale rectangulaire, sur le côté duquel est montée une platine (4). Un bras tubulaire sensiblement horizontal (5), en silice ou en silicium ou en carbure de silicium, prolongé à l'avant par une palette (6), est fixé par sa partie arrière sur la platine (4) au moyen de deux arceaux (7).

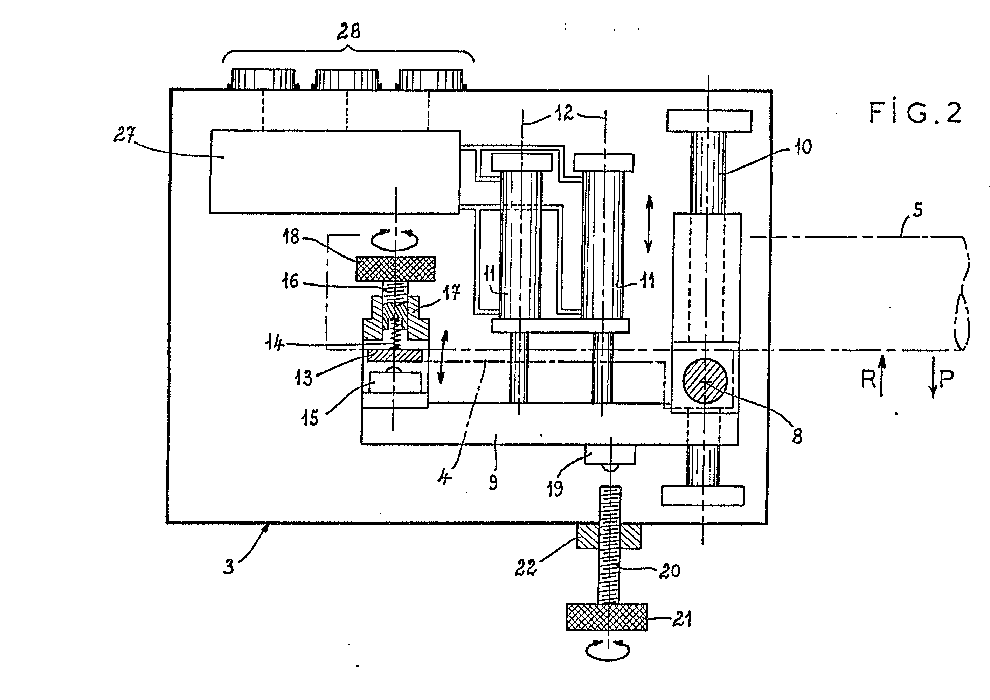

La platine (4) est montée mobile verticalement, et pivotante suivant un axe horizontal (8), sur le boîtier (3) dont le mécanisme intérieur est clairement montré à la figure 2. L'axe de pivotement (8) est solidaire d'un support (9), monté coulissant en direction verticale le long d'une colonne de guidage (10). Deux vérins pneumatiques (11), disposés suivant des axes parallèles verticaux (12), ont leurs corps fixés au boîtier (3) et leurs tiges liées au support (9).

La partie postérieure de la platine (4) comporte une patte latérale (13) engagée dans le boîtier (3), entre un ressort (14) et un contact électrique (15). Le ressort (14), agissant sur la face supérieure de la patte (13), est monté dans un logement d'une vis (16) tournant dans un écrou (17) solidaire du support (9), un bouton moleté (18) permettant d'actionner la vis (16). Le contact (15) est porté par le support (9) et situé au-dessous de la patte (13).

A sa partie inférieure, le support (9) porte encore un second contact électrique (19), placé en regard d'une butée réglable, portée par la partie inférieure du boîtier (3). Cette butée réglable est constituée par une vis (20) solidaire d'un bouton moleté (21) et tournant dans un écrou (22) fixé à la paroi inférieure du boîtier (3).

Comme le montre la figure 1, la paroi latérale de ce boîtier (3) présente une lumière verticale (23) traversée par l'arbre de pivotement (8) de la platine (4), et une autre lumière verticale (24) traversée par la patte (13) de la platine (4), cette seconde lumière (24) permettant également l'accès au bouton moleté (18).

La palette (6) située à l'avant du bras tubulaire (5) est prévue pour recevoir, comme le montre la figure 1, une pluralité de nacelles-supports (25) chargées de disques de silicium (26). D'une manière connue, chaque nacelle (25), réalisée en quartz ou en silicium, est formée de plusieurs barreaux qui présentent des séries de fentes dans lesquelles sont positionnés, les uns parallèlement aux autres et verticalement, tous les disques de silicium (26) placés sur la nacelle (25) considérée.

Le bras tubulaire (5), dont la palette (6) est chargée de plusieurs nacelles (25), est soumis à une force (P) résultant de son propre poids et de celui des nacelles, qui tend à le faire basculer, donc à faire basculer la platine (4) - voir figure 2. Ce basculement est compensé par le ressort (14), dont l'action peut être dosée à l'aide du bouton moleté (18). Lorsque le bras (5) est soumis à la seule force (P) compensée par l'action du ressort (14), la patte (13) de la platine (4) reste à distance du contact (15).

Sur la figure 2 sont encore indiqués le distributeur électro-pneumatique (27) pour l'alimentation et la commande des deux vérins (11), ainsi que des commandes manuelles (28). Les connexions pneumatiques et électriques du boîtier (3) avec l'extérieur n'ont pas été représentées.

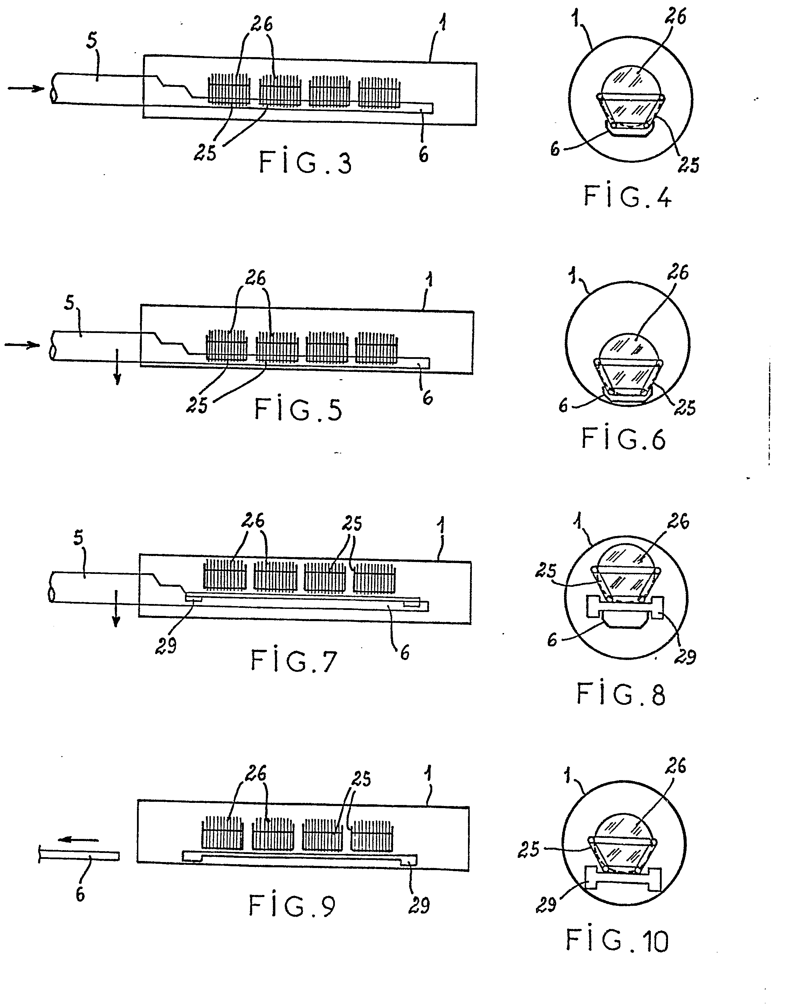

Un premier mode de fonctionnement de l'appareil d'enfournement précédemment décrit est illustré aux figures 3 et 4, qui sont respectivement une vue de côté et une vue en coupe transversale, très schématiques. La palette (6), chargée de plusieurs nacelles (25), est présentée en face de l'ouverture d'entrée du four, et le boîtier (3) est ensuite déplacé horizontalement le long de la glissière (2) par le mécanisme d'avance de celle-ci, de manière à introduire la palette (6) à l'intérieur du tube de traitement (1). La palette (6) est ainsi amenée, avec les nacelles (25) chargées de disques (26), dans une position "suspendue", c'est-à-dire qu'elle reste en l'air sans contact avec la paroi du tube (1), ceci pendant tout le traitement.

Un deuxième mode de fonctionnement est illustré par les figures 5 et 6, qui sont respectivement une vue de côté et une vue en coupe transversale, très schématiques. La palette (6) chargée de nacelles (25) est présentée et introduite dans le tube de traitement comme précédemment. Ensuite, les vérins (11) sont actionnés dans le sens commandant l'abaissement de la platine (4), donc du tube (5) avec la palette (6) et les nacelles (25). La palette (6) vient ainsi se déposer au fond du tube

6

(1). A ce moment, le tube (5) est allégé, la force (P) étant compensée par la réaction (R) due à l'appui contre la paroi du tube de traitement (1) - voir aussi figure 2. Il en résulte un basculement de la platine (4) qui, pivotant autour de l'axe (8), vient actionner le contact électrique (15) par sa patte (13). Ce contact (15) commande l'interruption de l'alimentation des vérins (11) dans le sens de la descente. La palette (6) reste au fond du tube (1) durant tout le traitement, et elle est ensuite relevée pour l'extraction des nacelles (25).

Enfin, un troisième mode de fonctionnement est indiqué aux figures 7 à 10. Les différentes nacelles (25) chargées de disques (26) sont ici placées sur un chevalet (29) constituant leur support commun. Le chevalet (29) est posé sur la palette (6). L'ensemble formé par la palette (6), le chevalet (29) et les nacelles (25) est d'abord introduit à l'intérieur du tube de traitement (1), par le mouvement d'avance du boîtier (3) - voir figures 7 et 8. Ensuite, les vérins (11) sont actionnés dans le sens de la descente, de sorte que tout cet ensemble est abaissé à l'intérieur du tube de traitement (1). A la fin de ce déplacement, le chevalet (29) vient reposer par ses pieds sur le fond du tube (1). La palette (6) poursuit encore son mouvement de descente. jusqu'à ce que le contact électrique (19) soit actionné par la butée (20) - voir figure 2. A ce moment, l'alimentation des vérins (11) est interrompue. Le boîtier (3) revient en arrière pour sortir du four la palette libérée (6) pendant le traitement, tandis que les nacelles (25) reposent sur le fond du tube (1) par l'intermédiaire du chevalet (29), comme le montrent les figures 9 et 10. En fin de traitement, la palette (6) revient chercher le chevalet (29) et les nacelles (25), pour les soulever et les extraire du tube (1), dans un mouvement inverse de celui de l'enfournement.

L'appareil peut comporter des moyens de sélection, permettant de choisir un fonctionnement soit manuel, soit automatique et programmé par l'ordinateur de pilotage du four.

Comme il va de soi, l'invention ne se limite pas à la seule forme de réalisation de cet appareil d'enfournement qui a été décrite ci-dessus, à titre d'exemple ; elle en embrasse, au contraire, toutes les variantes respectant le même principe, quels que soient les détails constructifs notamment dans le mécanisme intérieur du boîtier.

# REVENDICATIONS

1. Appareil d'enfournement de nacelles-supports de disques de silicium à l'intérieur d'un four de diffusion gazeuse, utilisé pour la fabrication de micro-circuits intégrés, caractérisé en ce qu'il comprend essentiellement un boîtier (3) monté déplaçable en translation le long d'une glissière horizontale (2) équipée d'un mécanisme d'avance, le boîtier (3) portant latéralement une platine (4), montée mobile verticalement et pivotante suivant un axe horizontal (8), sur laquelle est fixé un tube (5) en silice ou en silicium ou en carbure de silicium sensiblement horizontal prolongé par une palette (6) apte à recevoir une pluralité de nacelles-supports (25) chargées de disques de silicium (26) et à être introduite à l'intérieur du tube de traitement (1) du four.

2. Appareil d'enfournement selon la revendication 1, caractérisé en ce que le tube (5) en silice ou en silicium ou en carbure de silicium est fixé sur la platine (4) au moyen d'arceaux (7).

3. Appareil d'enfournement selon la revendication 1 ou 2, caractérisé en ce que l'axe de pivotement (8) de la platine (4) est solidaire d'un support (9) intérieur au boîtier (3), monté coulissant en direction verticale sur au moins un guide (10), et déplaçable le long de ce guide vertical (10) par au moins un vérin (11), ledit support (9) comportant des moyens (14 à 18) sensibles au couple de basculement de la platine (4) résultant des efforts exercés sur le bras (5,6), ces moyens agissant sur l'alimentation du ou des vérins (11).

4. Appareil d'enfournement selon la revendication 3, caractérisé en ce que lesdits moyens comprennent un ressort (14) et un contact électrique (15) disposés de part et d'autre d'une patte (13) faisant saillie latéralement sur la platine (4) et engagée à l'intérieur du boîtier (3).

5. Appareil d'enfournement selon la revendication 4, caractérisé en ce que le ressort (14) est pressé contre la patte latérale (13) de la platine (4) au moyen d'une vis (16) solidaire d'un bouton de réglage (18), permettant de modifier la sensibilité au couple de basculement de la platine (4).

6. Appareil d'enfournement selon l'une quelconque des revendications 3 à 5, caractérisé en ce que le support (9) de la platine (4) porte un autre contact électrique (19) qui coopère avec une butée réglable (20) montée sur le boîtier (3), et qui agit sur l'alimentation du ou des vérins (11).

7. Appareil d'enfournement selon l'une quelconque des revendications 1 à 6, caractérisé en ce que la palette (6) prolongeant le tube en silice (5) est prévue pour recevoir, et déposer au fond du tube de traitement (1) du four, un chevalet (28) sur lequel sont placées les nacelles-supports (25) chargées de disques de silicium (26), les déplacements du boîtier (3) et de la platine (4) étant commandés de manière à effectuer le retrait de la palette (6) hors du tube de traitement (1), après dépose du chevalet (28).

FIG.1

0158570

FIG.2

0158570

0158570

FIG.3

FIG.4

FIG.5

FIG.6

FIG.7

FIG.8

FIG.9

FIG.10

Office européen
des brevets

**RAPPORT DE RECHERCHE EUROPEENNE**

EP 85 42 0039

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| A | EP-A-0 093 504 (HERAEUS QUARZSCHMELZE) <br> * Revendication 1; figure 1 * <br> --- | 1,2 | C 30 B 31/10 |
| A | TECHNICAL DIGEST-WESTERN ELECTRIC, no. 65, janvier 1982, pages 15,16, New York, US; G.W. GROSSMANN et al.: "Insertion tool for furnace boat" <br> * Page 15, figures 1-4 * <br> ----- | 1,2 | |

DOMAINES TECHNIQUES RECHERCHES (Int. Cl.4)

C 30 B 31/10

Le présent rapport de recherche a été établi pour toutes les revendications

| Lieu de la recherche | Date d'achèvement de la recherche | Examinateur |
|---|---|---|
| LA HAYE | 11-06-1985 | BRACKE P.P.J.L. |

OEB Form 1503 03 82